Europäisches Patentamt

European Patent Office

Office européen des brevets

(19)

(11) Veröffentlichungsnummer: **0 089 610**

**A1**

(12) # EUROPÄISCHE PATENTANMELDUNG

(21) Anmeldenummer: 83102563.0

(22) Anmeldetag: 15.03.83

(51) Int. Cl.³: **C 01 B 33/02**
**C 30 B 15/00, C 30 B 29/06**

(30) Priorität: 19.03.82 DE 3210141

(43) Veröffentlichungstag der Anmeldung:
28.09.83 Patentblatt 83/39

(84) Benannte Vertragsstaaten:
DE FR GB IT

(71) Anmelder: SIEMENS AKTIENGESELLSCHAFT
Berlin und München Wittelsbacherplatz 2
D-8000 München 2(DE)

(72) Erfinder: Reuschel, Konrad, Dr. phil. nat.
Rosengasse 18
D-8011 Vaterstetten(DE)

(54) Verfahren zum Herstellen von für insbesondere Solarzellen verwendbarem Silicium.

(57) Die Erfindung betrifft ein Verfahren zum Herstellen von für Solarzellen verwendbarem Silicium durch Aufbereitung von Siliciumdioxid technischer Qualität mittels des Lichtbogenverfahrens (3), bei dem das durch das Lichtbogenverfahren (3) erhaltene Silicium durch tiegelfreies Zonenziehen (5) von störenden Verunreinigungen befreit wird.

EP 0 089 610 A1

SIEMENS AKTIENGESELLSCHAFT
Berlin und München

Unser Zeichen
VPA 82 P 1 2 0 1 E

Verfahren zum Herstellen von für insbesondere Solarzellen verwendbarem Silicium

Die Erfindung betrifft ein Verfahren zum Herstellen von
für insbesondere Solarzellen verwendbarem Silicium durch
Aufbereitung von Siliciumdioxid technischer Qualität
mittels des Lichtbogenverfahrens, bei dem als Ausgangsmaterialien für die Reduktion im Lichtbogen Siliciumdioxid und Kohle mit jeweils geringem Borgehalt verwendet werden und bei dem das nach der Reduktion erhaltene
schmelzflüssige Silicium in einen polykristallinen Siliciumkörper übergeführt wird.

Bei einem bekannten Verfahren (vergleiche DE-OS
27 22 783) zum Reinigen von technischem Silicium wird
dieses zunächst fein zermahlen und anschließend oder
gleichzeitig mit einer Säurelösung behandelt. Dieser mechanischen und chemischen Reinigung, bei der ein Teil
der Verunreinigungen aus dem Siliciumgranulat gelöst
wird, muß aber noch ein Kristallziehprozeß folgen, um so
die für die Fertigung von Solarzellen erforderliche Qualität des Siliciums zu erreichen. Dadurch wird dieses
bekannte Verfahren insgesamt aufwendig.

Es ist daher Aufgabe der Erfindung, ein Verfahren der
eingangs genannten Art zu schaffen, mit dem auf einfache
Weise für Solarzellen geeignetes Silicium aus Siliciumdioxid hergestellt werden kann.

Diese Aufgabe wird bei einem Verfahren nach dem Oberbegriff des Patentanspruchs 1 erfindungsgemäß dadurch gelöst, daß der Siliciumkörper ein Siliciumstab ist, in

Kot 1 Dx / 18.03.1982

den das nach der Reduktion erhaltene Silicium im Schutzgas oder Vakuum verarbeitet wird, und daß der so erhaltene Siliciumstab durch anschließendes tiegelfreies Zonenziehen von den störenden Verunreinigungen befreit wird.

Bei der Erfindung wird also das im Lichtbogenverfahren hergestellte Silicium im Schutzgas oder im Vakuum zu polykristallinen Stäben gegossen oder in einer Tiegelziehanlage zu solchen gezogen. In einem weiteren Verfahrensschritt wird dann der so gewonnene polykristalline Siliciumstab durch tiegelfreies Zonenziehen, das gegebenenfalls ein- oder mehrmals vorgenommen wird, von den störenden Verunreinigungen mit Ausnahme von Bor so weit befreit, daß der Siliciumstab für Halbleiterbauelemente, wie beispielsweise Solarzellen oder als Substratmaterial für integrierte Bauelemente, eingesetzt werden kann.

Durch das tiegelfreie Zonenziehen wird der Siliciumstab äußerst wirksam von den störenden Verunreinigungen gereinigt, was lediglich für Bor nicht gilt. Daher sollten als Ausgangsmaterialien Siliciumdioxid und Kohle mit jeweils geringem Borgehalt verwendet werden. Selbstverständlich ist es aber auch möglich, mit Bor angereichertes Siliciumdioxid und Kohle von höherem Borgehalt zuvor einer Behandlung zu unterziehen, bei der Bor aus dem Siliciumdioxid bzw. der Kohle abgeführt wird.

Das erfindungsgemäße Verfahren ist hervorragend zum Herstellen von für Solarzellen verwendbarem Silicium geeignet, da dieses Silicium einerseits mit möglichst geringem Aufwand bzw. niedrigen Kosten erzeugbar sein muß und andererseits aber auch einen hohen Wirkungsgrad für die Umsetzung der Sonnenenergie in elektrische Energie aufweisen sollte. Dieser Wirkungsgrad bei der Umsetzung hängt bekanntlich stark von der Lebensdauer der Minoritätsladungsträger ab, welche wiederum wenig Rekombinationszentren im Silicium voraussetzt.

Die Lebensdauer der Minoritätsladungsträger wird in erster Linie durch metallische Fremdstoffe begrenzt. Die Konzentration der metallischen Fremdstoffe kann wirksam durch Zonenziehen herabgesetzt werden, weil der Verteilungskoeffizient K für die meisten metallischen Verunreinigungen sehr klein ist, so daß dadurch aus dem polykristallinen Siliciumstab das von den störenden Verunreinigungen befreite und für Solarzellen besonders geeignete Silicium erhalten wird. So betragen beispielsweise die Verteilungskoeffizienten $K_o = c_s/c_f$ für Ni $3 \cdot 10^{-5}$, für Fe $8 \cdot 10^{-6}$, für Au $2,5 \cdot 10^{-5}$, für Ti $3,6 \cdot 10^{-6}$, für Cr $1,1 \cdot 10^{-5}$, für Mn $1 \cdot 10^{-5}$ und für Ta $1 \cdot 10^{-7}$, wobei $c_s$ die Konzentration in festem Si und $c_f$ die Konzentration in flüssigem Si bedeuten. Störend sind insbesondere die Atome der Nebengruppenelemente der 4. bis 7. Hauptgruppe des Periodensystems (vergleiche hierzu auch DOE-Report 1981).

Nachfolgend wird die Erfindung noch an Hand eines Flußdiagramms erläutert, das den Ablauf des erfindungsgemäßen Verfahrens zeigt:

In einem Verfahrensschritt 1 wird Siliciumdioxid von Bor gereinigt. Unabhängig hiervon wird in einem Verfahrensschritt 2 Kohle ebenfalls von Bor gereinigt. Das gereinigte Siliciumdioxid wird in einem Verfahrensschritt 3 mit der gereinigten Kohle reduziert, wodurch schmelzflüssiges Silicium erhalten wird, das in einem Verfahrensschritt 4 in einen polykristallinen Stab gegossen

**0089610**

wird. Anstelle dieses Verfahrensschritts 4 kann das durch den Lichtbogenprozeß erhaltene Silicium auch in einer Tiegelziehanlage verarbeitet werden. Anschließend wird in einem Verfahrensschritt 5 der Siliciumstab einem tiegelfreien Zonenziehen unterworfen, um so das Silicium von den störenden Verunreinigungen zu befreien.

1 Figur
4 Patentansprüche

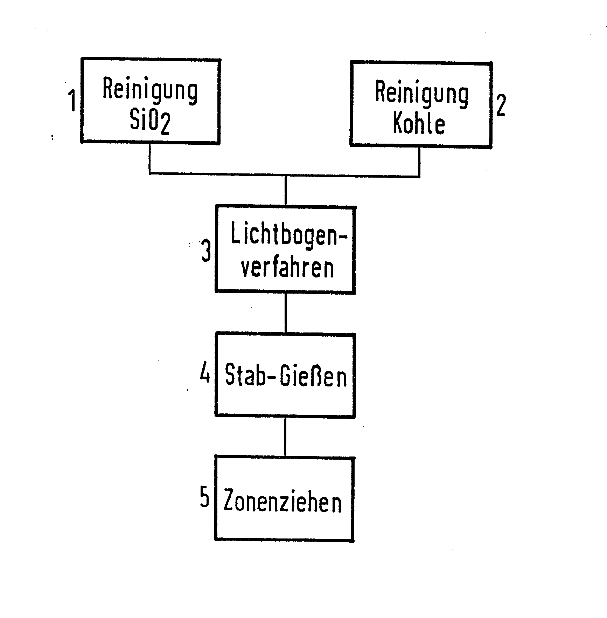

Patentansprüche

1. Verfahren zum Herstellen von für insbesondere Solarzellen verwendbarem Silicium durch Aufbereitung von Siliciumdioxid ($SiO_2$) technischer Qualität mittels des Lichtbogenverfahrens, bei dem als Ausgangsmaterialien für die Reduktion im Lichtbogen Siliciumdioxid und Kohle mit jeweils geringem Borgehalt verwendet werden und bei dem das nach der Reduktion erhaltene schmelzflüssige Silicium in einen polykristallinen Siliciumkörper übergeführt wird, d a d u r c h   g e k e n n z e i c h - n e t ,   daß der Siliciumkörper ein Siliciumstab ist, in den das nach der Reduktion erhaltene Silicium im Schutzgas oder Vakuum verarbeitet wird, und daß der so erhaltene Siliciumstab durch anschließendes tiegelfreies Zonenziehen von den störenden Verunreinigungen befreit wird.

2. Verfahren nach Anspruch 1, d a d u r c h   g e - k e n n z e i c h n e t ,   daß das nach der Reduktion erhaltene Silicium zu dem Siliciumstab gegossen wird.

3. Verfahren nach Anspruch 1, d a d u r c h   g e - k e n n z e i c h n e t ,   daß das nach der Reduktion erhaltene Silicium in einer Tiegelziehanlage zu dem Siliciumstab verarbeitet wird.

4. Verfahren nach einem der Ansprüche 1 bis 3, d a - d u r c h   g e k e n n z e i c h n e t ,   daß das tiegelfreie Zonenziehen ein- oder mehrmals durchgeführt wird.

| | |
|---|---|
| 1 | Reinigung SiO$_2$ |
| | Reinigung Kohle | 2 |

3 | Lichtbogen-verfahren

4 | Stab-Gießen

5 | Zonenziehen

**0089610**
Nummer der Anmeldung

## EUROPÄISCHER RECHERCHENBERICHT

EP 83 10 2563

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X | DE-B-2 455 012 (SIEMENS) * Anspruch 1 * | 1 | C 01 B 33/02 C 30 B 15/00 C 30 B 29/06 |
| A | DE-A-3 013 319 (DOW CORNING CORP.) * Seiten 7, 8, 31-33 * | | |
| A | EP-A-0 002 135 (UNION CARBIDE) | | |
| D,A | DE-A-2 722 783 (WACKER-CHEMITRONIC) | | |
| A | CHEMIE.INGENIEUR.TECHNIK, Band 50, Nr. 8, 1978, Weinheim, H. SILBERNAGEL "Grotechnische Herstellung von Reinstsilicium", Seiten 611-617 * Seiten 614-615 * | | |

RECHERCHIERTE SACHGEBIETE (Int. Cl. 3)

C 01 B 33/00

Der vorliegende Recherchenbericht wurde für alle Patentansprüche erstellt.

| Recherchenort BERLIN | Abschlußdatum der Recherche 03-06-1983 | Prüfer KESTEN W |
|---|---|---|